# EUROPEAN PATENT APPLICATION

(11) **EP 4 683 442 A1**
(43) Date of publication of application: **21.01.2026**
(21) Application number: 23952373.1
(22) Date of filing: 29.11.2023
(51) Int. Cl.: H05K 7/20, H01L 23/367

(54) **ANTENNA MODULE MOUNTED ON VEHICLE**

(30) Priority: 15.09.2023 KR 20230123069
(71) Applicant: LG Electronics Inc., Yeongdeungpo-gu Seoul 07336 (KR)
(72) Inventor: KIM, Doekyong, Seoul 06772 (KR)
(74) Representative: Vossius & Partner Patentanwälte Rechtsanwälte mbB
(86) International application number: PCT/KR2023/019408
(87) International publication number: WO 2025/058134

(57) **Abstract**

This antenna module mounted on a vehicle comprises: a PCB having at least one antenna element disposed on a first surface thereof; a second PCB having a first surface coupled to a second surface of the PCB, a first electronic component disposed on the first surface, and a second electronic component disposed on the second surface; a first heat sink disposed to be in contact with the first electronic component disposed on the first surface of the second PCB; a second heat sink disposed to be in contact with the second electronic component disposed on the second surface of the second PCB; and a hole region formed in the central portion of the PCB to accommodate the first electronic component.

## Description

### Technical Field

The present disclosure relates to an antenna module mounted on a vehicle. A particular implementation relates to an antenna module having a plurality of communication modules and a heat dissipation structure, and a vehicle including the antenna module.

### Background Art

Electronic devices may be classified into mobile/portable terminals and stationary terminals according to mobility. Meanwhile, with commercialization of wireless communication systems that use LTE communication technologies, in recent years, the electronic devices have provided various services. In addition, in the future, it is also expected that the electronic devices may provide various services, with commercialization of wireless communication systems that use 5G communication technologies. Meanwhile, some of LTE frequency bands may be allocated to provide 5G communication services.

In this regard, mobile terminals may be configured to provide 5G communication services in various frequency bands. Recently, attempts have been made to provide 5G communication services using a Sub6 band that is a band of 6 GHz or less. In the future, however, it is also expected to provide 5G communication services by using a millimeter-wave (mmWave) band in addition to the Sub6 band for a faster data rate.

Recently, the need to provide these communication services through a vehicle has been increased. Meanwhile, regarding communication services, there has also appeared a need for fifth-generation (5G) communication services that are next-generation services, as well as for existing communication services, such as Long Term Evolution (LTE) services.

Meanwhile, a vehicle body and roof are made of metallic materials, which cause a problem with blocking radio waves. Accordingly, a separate antenna module structure may be arranged on top of the vehicle body or the vehicle roof. Alternatively, when the antenna module structure is arranged below the vehicle body or roof, a portion of the vehicle body or roof corresponding to an antenna arrangement region may be made of a non-metallic material.

However, in terms of design, the vehicle body or roof needs to be integrally arranged. In this case, the exterior of the vehicle body or roof may be made of a metallic material. This may cause antenna efficiency to be drastically lowered due to the vehicle body or roof.

Additionally, an antenna module mounted on the vehicle may be equipped with electronic components including a plurality of communication modules. An arrangement structure of the electronic components may be arranged on different substrates or different surfaces of a same substrate. An optimal heat dissipation structure is needed in consideration of the arrangement structure of the electronic components arranged on different substrates or different surfaces of a same substrate.

### Disclosure of Invention

### Technical Problem

One aspect of the specification is to solve the aforementioned problems and other drawbacks. An objective of this specification is to provide an antenna module including a plurality of communication modules and a heat dissipation structure in a vehicle.

An objective of this specification is to implement an optimal heat dissipation structure by taking into account an arrangement structure of electronic components placed on both surfaces of a substrate or on different substrates.

An objective of this specification is to provide an antenna module including a plurality of communication modules and a heat dissipation structure in a vehicle.

An objective of this specification is to provide an optimal heat dissipation structure by taking into account optimal shapes and arrangement structures of a plurality of covers and heat sinks.

An objective of this specification is to optimize a heat dissipation structure for each electronic component arranged on a plurality of surfaces of a printed circuit board (PCB).

An objective of this specification is to improve heat dissipation performance while minimizing a whole height of an antenna module.

An objective of this specification is to improve antenna performance while a height of the antenna module mounted in the vehicle is maintained at a certain level or greater.

An objective of this specification is to apply, to a vehicle, a heat dissipation structure in which arrangement structures of antennas capable of operating in a wide band and electronic components are taken into account to thereby support various communication systems.

An objective of this specification is to efficiently dissipate heat generated from an electronic component to outside the antenna module through a plurality of heat sink structures.

An objective of this specification is to provide an optimized heat dissipation structure by taking into account a heat transfer path along a signal path within the antenna module.

### Solution to Problem

To achieve these and other advantages and in accordance with the purpose of this specification, as embodied and broadly described herein, there is provided an antenna module mounted on a vehicle, the antenna module including: a printed circuit board (PCB) having at least one antenna element arranged on a first surface; a second PCB having a first surface combined with a second surface of the PCB, a first electronic component arranged on the first surface, and a second electronic component arranged on a second surface; a first heat sink arranged to be in contact with the first electronic component arranged on the first surface of the second PCB; a second heat sink arranged to be in contact with the second electronic component arranged on the second surface of the second PCB; and a hole region arranged in a central portion of the PCB to accommodate the first electronic component.

According to an embodiment, a first width of a lower end of the first heat sink may be configured to be smaller than a width of the hole region so that at least a portion of the first heat sink is inserted into the hole region. The inserted at least a portion of the first heat sink may be configured to be in contact with the first electronic component accommodated in the hole region to dissipate heat generated from the first electronic component. A second width of the second heat sink may be configured to be greater than a width of the second PCB to dissipate heat generated from the second electronic component.

According to an embodiment, the antenna module may further include a first cover configured to be combined with a side surface portion of an upper region of the first heat sink. A third width of an opening region of the first cover into which the first heat sink is inserted may be configured to be greater than the first width of the lower end of the first heat sink.

According to an embodiment, the first cover may include a horizontal region arranged in parallel with a horizontal plane, and a first inclined region and a second inclined region each arranged to be inclined at a predetermined angle with respect to the horizontal plane. The first heat sink may be arranged in the horizontal region of the first cover.

According to an embodiment, the first heat sink may include: a first metal structure configured to have a first width and a first height such that at least a portion of the first metal structure is inserted into the hole region of the PCB; a second metal structure connected to the first metal structure and arranged on an upper region of the first metal structure to have a second height in a Z-axis direction; and a third metal structure connected to the second metal structure, arranged on an upper region of the second metal structure to have a third height in the Z-axis direction, and having the side surface portion combined with the first cover. The third height of the third metal structure may be configured to be greater than the second height of the second metal structure. The second height of the second metal structure may be configured to be greater than the first height of the first metal structure.

According to an embodiment, the third metal structure may include a plurality of metal members spaced apart from each other in parallel with a horizontal axis direction and arranged in the Z-axis direction. A width of the second metal structure may be configured to be identical to a third width of the third metal structure. The first width of the first metal structure may be configured to be smaller than the third width of each of the second metal structure and the third metal structure.

According to an embodiment, the antenna module may further include a thermoelectric element located between the second heat sink and the second electronic component arranged on the second surface of the second PCB to absorb heat generated from the second electronic component. The first electronic component arranged on the first surface of the second PCB may be coupled to a lower end of the first heat sink through a thermoelectric material. A first surface of the thermoelectric element may be in contact with the second electronic component through the thermoelectric material, and a second surface of the thermoelectric element may be in contact with the second heat sink.

According to an embodiment, the second heat sink may be arranged in the horizontal region of the first cover to overlap the first heat sink in the Z-axis direction. The second heat sink may include: a fourth metal structure in contact with the thermoelectric element and configured to have the second width and a fourth height; and a fifth metal structure connected to the fourth metal structure and configured to have the second width and a fifth height. The fourth metal structure may include a plurality of second metal members spaced from each other in parallel with the horizontal axis direction and arranged in the Z-axis direction. The fourth height of the fourth metal structure may be configured to be greater than the fifth height of the fifth metal structure.

According to an embodiment, the first electronic component may include at least one among a modem, a radio frequency (RF) transceiver, a power management chip, and a first power amplifier. The second electronic component may include a direct current (DC)/DC converter and a second power amplifier. The first power amplifier may operate in a low band (LB), and the second power amplifier may operate in a mid band (MB) and a high band (HB). Heat generated from the first power amplifier may be dissipated through the first heat sink, and heat generated from the second power amplifier may be dissipated through the second heat sink.

A vehicle having an antenna module mounted thereon according to another aspect of this specification is provided. The vehicle may include: an antenna module arranged on a lower portion of a roof of the vehicle; and a telematics module operatively coupled to the antenna module and configured to communicate with at least one among an adjacent vehicle, a road side unit (RSU), and a base station. The antenna modules may include: a printed circuit board (PCB) having at least one antenna element arranged on a first surface; a second PCB having a first surface combined with a second surface of the PCB, a first electronic component arranged on the first surface, and a second electronic component arranged on a second surface; a first heat sink arranged to be in contact with the first electronic component arranged on the first surface of the second PCB; a second heat sink arranged to be in contact with the second electronic component arranged on the second surface placed on the second PCB; and a hole region arranged in a central portion of the PCB to accommodate the first electronic component.

According to an embodiment, a first width of a lower end of the first heat sink may be configured to be smaller than a width of the hole region so that at least a portion of the first heat sink is inserted into the hole region. The inserted at least a portion of the first heat sink may be configured to be in contact with the first electronic component accommodated in the hole region to dissipate heat generated from the first electronic component. A second width of the second heat sink may be configured to be greater than a width of the second PCB to dissipate heat generated from the second electronic component.

### Advantageous Effects of Invention

Hereinafter, technical effects of such an antenna module mounted on a vehicle and the vehicle including the same are described.

According to this specification, an antenna module having a plurality of communication modules and a heat dissipation structure may be provided in a vehicle.

According to this specification, an optimal heat dissipation structure may be provided through optimal shapes and arrangement structures of a plurality of covers and heat sinks.

According to this specification, shapes of metal structures of first and second heat sinks may be optimized for a plurality of regions, respectively, to optimize a heat dissipation structure for each of electronic components arranged on a plurality of surfaces of a printed circuit board (PCB).

According to this specification, a first heat sink may be arranged to be coupled to an upper cover to improve heat dissipation performance while minimizing a whole height of the antenna module.

According to this specification, heat generated from an electronic component may be dissipated to an upper region and a lower region through a first heat sink coupled to an upper cover and a second heat sink arranged in a lower region of a lower cover.

According to this specification, an optimized heat dissipation structure may be proposed by taking into account a heat transfer path along a signal path from a power amplifier to antenna elements capable of operating in a wide band.

Further scope of applicability of the disclosure will become apparent from the foregoing detailed description. It should be understood, however, that the detailed description and specific examples, such as the preferred embodiment of the present disclosure, are given by way of illustration only, since various changes and modifications within the spirit and scope of the present disclosure will be apparent to those skilled in the art.

### Brief Description of Drawings

FIG. 1 is a diagram illustrating a vehicle according to an embodiment of this specification.
FIGS. 2A to 2C illustrate a structure in which an antenna module may be mounted in a vehicle according to this specification, with respect to the vehicle including the antenna module.
FIG. 3 is a configuration diagram of a vehicle according to an embodiment of this specification.
FIG. 4 illustrates structures of a second printed circuit board (PCB) capable of being stacked with a first PCB which is a main PCB, wherein the second PCB is a network access device (NAD) substrate according to embodiments.
FIG. 5 illustrates an enlarged view and a cross-sectional view of a structure in which the PCB and the second PCB are stacked with each other.
FIG. 6 is a cross-sectional view of a vehicle antenna module including a plurality of heat sinks according to this specification.
FIG. 7 illustrates a structure in which structures of first and second heat sinks shown in FIG. 6 are combined with the PCB and the second PCB.
FIG. 8 is an exploded perspective view of the vehicle antenna module of FIG. 6.
FIG. 9 is a perspective view of a vehicle antenna module including a first cover configured to have a horizontal structure and an inclined structure.
FIG. 10 is a cross-sectional view of an antenna module taken along line AA' in which first and second heat sinks are included.
FIG. 11 is a cross-sectional view of the antenna module take along line BB' in which the second heat sink is included.
FIG. 12 illustrates electronic components arranged on first and second surfaces of the second PCB arranged in the antenna module according to the present specification.
FIG. 13 shows the electronic components arranged on the first and second surfaces of the second PCB of FIG. 12, and values of power consumption at particular temperatures.
FIG. 14 is a conceptual diagram of a heat dissipation mechanism for electronic components on the PCB and the second PCB having a plurality of heat sources.
FIG. 15 is a configuration diagram of a vehicle including the antenna module according to this specification.

### Mode for the Invention

A description will now be given in detail according to embodiments disclosed herein, with reference to the accompanying drawings. For the sake of a brief description with reference to the drawings, the same or equivalent components may be provided with the same reference numbers, and the description thereof will not be repeated. Suffixes "module" and "unit" used for components used in the following description are merely intended for easy description of the specification, and each suffix itself is not intended to give any special meaning or function. In describing the embodiments disclosed herein, moreover, the detailed description will be omitted when a specific description for publicly known technologies to which the disclosure pertains is judged to obscure the gist of the disclosure. The accompanying drawings are used to help easily understand the technical idea of the disclosure and it should be understood that the idea of the disclosure is not limited by the accompanying drawings. The idea of the present disclosure should be construed to extend to any alterations, equivalents, and substitutes besides the accompanying drawings.

It will be understood that although the terms first, second, and the like may be used herein to describe various elements, these elements should not be limited by these terms. These terms are generally only used to distinguish one element from another.

It will be understood that when an element is referred to as being "connected with" another element, the element may be connected with the another element or intervening elements may also be present. In contrast, when an element is referred to as being "directly connected with" another element, there are no intervening elements present.

The singular forms are intended to include the plural forms as well, unless the context clearly indicates otherwise.

Terms "include" or "have" as used herein should be understood that they are intended to indicate the existence of a feature, a number, a step, an element, a component, or a combination thereof disclosed in the specification, and it may also be understood that the existence or additional possibility of one or more other features, numbers, steps, elements, components, or combinations thereof are not excluded in advance.

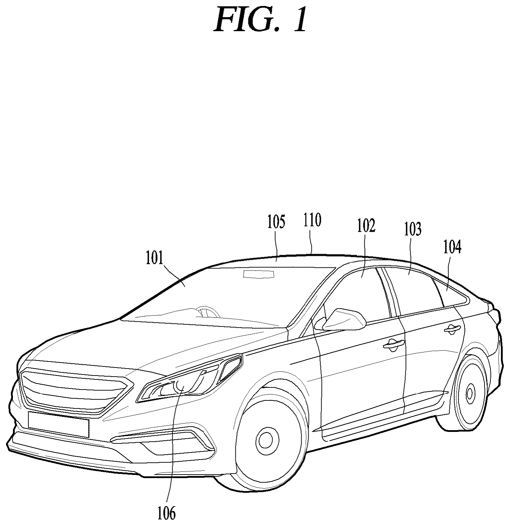

Hereinafter, an antenna module according to this specification will be described in detail. In this regard, FIG. 1 is a diagram illustrating a vehicle according to an embodiment of this specification.

Referring to FIG. 1, a vehicle 1 may have at least one communication antenna. The vehicle 1 may transmit and/or receive signals of various frequency bands using the communication antenna. The vehicle 1 may perform communications, such as vehicle-to-vehicle (V2V), vehicle-to-infrastructure (V2I), vehicle-to-pedestrian (V2P), vehicle-to-network (V2N), and the like.

The antenna may include a substrate made of a material such as olyethylene terephthalate (PET), and an antenna pattern arranged on the substrate. For example, the antenna may be a transparent antenna.

The antenna may be arranged on glass of the vehicle 1. The antenna may be combined with or attached to a front windshield 101, pieces of door glass 102, 103, quarter glass 104, a rear windshield (not illustrated), a side mirror (not illustrated), a sunroof 105, or lamp glass 106. For example, the antenna may be a transparent antenna. As another example, the antenna may be placed in a region in which a roof 110 is arranged on an upper portion of the vehicle 1.

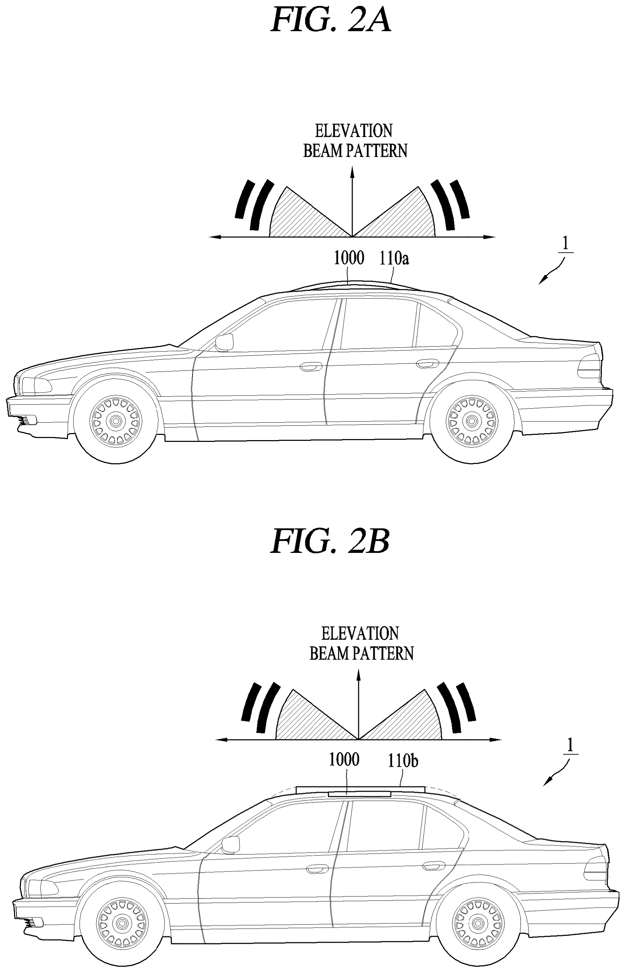

Meanwhile, FIGS. 2A to 2C illustrate a structure in which an antenna module may be mounted in a vehicle according to this specification, with respect to the vehicle including the antenna module.

Referring to FIGS. 2A to 2C, in this specification, to improve an appearance of the vehicle and maintain telematics performance during collision, a general shark fin antenna is replaced with a flat antenna having a non-protruding shape. In addition, this specification proposes an antenna in which a long term evolution (LTE) antenna and a fifth generation (5G) antenna are integrated in consideration of 5G communication while providing a general mobile communication service (LTE).

Referring to FIG. 2A, an antenna module 1000 is arranged a roof placed on the vehicle 1. In FIG. 2A, with respect to the antenna module 1000, a radome 110a for protection from an external environment and external impacts while the vehicle travels may surround the antenna system 1000. The radome 110a may be made of a dielectric material capable of transmitting a radio signal sent/received between the antenna system 1000 and an infrastructure such as a base station or other vehicles.

Referring to FIG. 2B, configuration may be performed such that the antenna module 1000 is arranged within a roof structure 110b of the vehicle 1, and at least a part of the roof structure 110b is implemented with a non-metallic material. At this time, at least a part of the roof structure 110b of the vehicle may be implemented with a non-metallic material to include a dielectric material capable of transmitting a radio signal sent/received between the antenna system 1000 and an infrastructure such as a base station or other vehicles.

Meanwhile, referring to FIGS. 2A and 2B, a region in which a beam pattern is generated by an antenna included in the antenna module 1000 mounted in the vehicle needs to extend to an area located upward by a predetermined angle from a horizontal region.

In this regard, a peak of an elevation beam pattern of the antenna included in the antenna module 1000 does not need to be located along a boresight. Therefore, a peak of the elevation beam pattern of the antenna needs to extend to an area located upward by a predetermined angle from the horizontal region. For example, the elevation beam pattern of the antenna may be generated in a hemisphere shape as shown in FIGS. 2A and 2B. Additionally, since a beam peak is located within a range of low elevation angles (e.g., 30 degrees), the elevation beam pattern of the antenna may be referred to as a low elevation beam pattern.

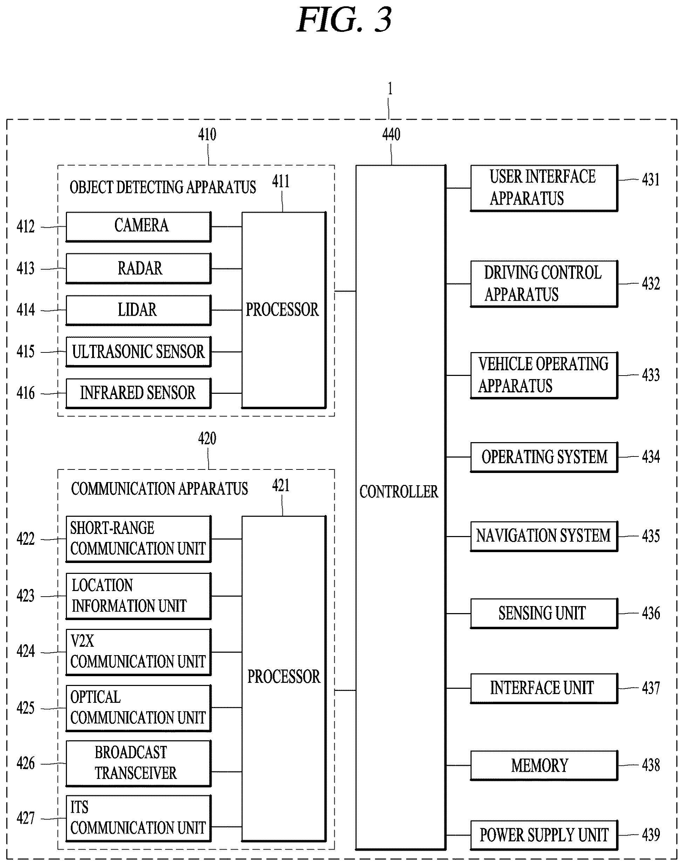

FIG. 3 is a configuration diagram of a vehicle according to an embodiment of this specification. Referring to FIG. 3, the vehicle 1 may include an object detection device 410, a communication device 420, a user interface device 431, a driving operation device 432, a vehicle drive device 433, a driving system 434, a navigation system 435, a sensing unit 436, an interface unit 437, a memory 438, a power supply unit 439, and/or a controller 440. On the other hand, the vehicle 1 may further include components other than the components described above, or some of the components described above may not be included.

The object detection device 410 may be a device for detecting an object located outside the vehicle 1. For example, the object detection device 410 may include a processor 411, a camera 412, a radar 413, a LiDAR 414, an ultrasonic sensor 415, and/or an infrared sensor 416.

The communication device 420 may be a device for performing communication with an external device. The communication device 420 may include at least one among a transmitting antenna, a receiving antenna, and a radio frequency (RF) circuit or an RF device capable of implementing various communication protocols to perform communication. For example, the communication device 420 may include a processor 421, a short-range communication unit 422, a location information unit 423, a vehicle-to-everything (V2X) communication unit 424, an optical communication unit 425, a broadcast transceiver 426 and/or an ITS communication unit 427.

The user interface device 431 may be a device for interaction between the vehicle 1 and a user. The vehicle 1 may implement a user interface (UI) or a user experience (UX) through the user interface device 431.

The driving operation device 432 may be a device for receiving a user input for driving. The vehicle drive device 433 may be a device for electrically controlling drive of various devices within the vehicle 1. The driving system 434 may be a system for controlling various driving operations of the vehicle 1. The navigation system 435 may provide navigation information. The sensing unit 436 may sense a state of the vehicle 1.

The interface unit 437 may function as an interface with various types of external devices connected with the vehicle 1. The memory 438 may store basic data for units of the vehicle 1, control data for controlling operations of the units, input or output data, and the like. The power supply unit 439 may supply power needed for operations of respective components. The controller 440 may control overall operations of each unit within the vehicle 1. The controller 440 may be implemented as an electronic control unit (ECU) and/or a telematics control unit (TCU).

Meanwhile, referring to FIGS. 1 to 3, an antenna system mounted in the vehicle may be arranged inside the vehicle, on a roof of the vehicle, inside the roof, or inside a roof frame. In this regard, the antenna system disclosed herein may be configured to operate in a low band (LB), a mid band (MB), and a high band (HB) of a 4G LTE system and a SUB6 band of a 5G NR system.

Hereinafter, a vehicle antenna module according to this specification is to be described. Substrates placed inside the vehicle antenna module may have electronic components arranged on both a first surface and a second surface. Thus, a size occupied by the substrates may be reduced. In particular, a network access device (NAD) substrate on which electronic components for 5G wireless communication are placed may be implemented as a double-sided substrate. The NAD substrate implemented as a double-sided substrate may be configured to have a double-sided heat dissipation structure. Meanwhile, the NAD substrate having a reduced size may be placed in an optimal layout on a main printed circuit board (PCB).

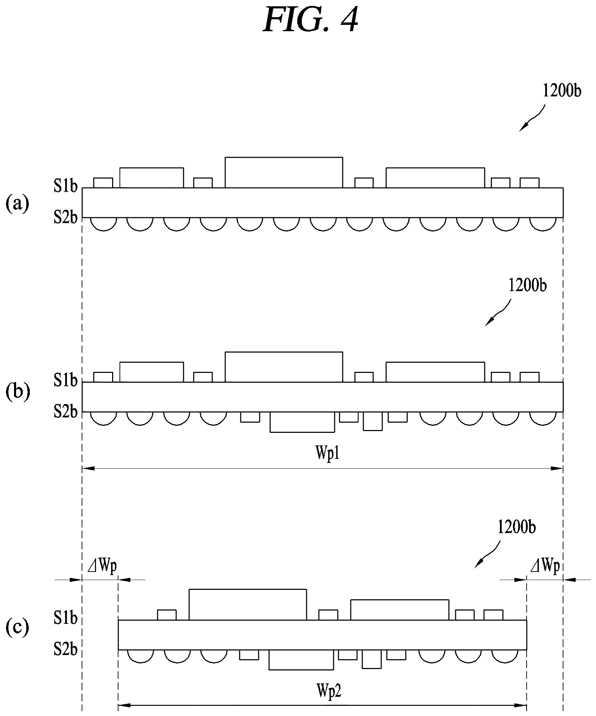

In this regard, FIG. 4 illustrates structures of a second PCB capable of being stacked with a first PCB which is a main PCB, wherein the second PCB is a NAD substrate according to embodiments. (a) of FIG. 4 illustrates a structure in which electronic components are arranged only on a first surface S1b of a second PCB 1200b. Ball grids for electrical connection with a PCB which is the main substrate may be arranged on a second surface S2b of the second PCB 1200b.

(b) of FIG. 4 illustrates a second structure in which first electronic components are arranged on the first surface S1b of the second PCB 1200b and second electronic components are arranged on the second surface S2b. In (b) of FIG. 4, the second PCB 1200b may be configured to have a first width W1p. The second electronic components may be arranged at a central portion of the second surface S2b of the second PCB 1200b. Ball grids for electrical connection with the PCB which is the main substrate may be arranged on one side and another side of the second surface S2b of the second PCB 1200b.

(c) of FIG. 4 illustrates a third structure in which the first electronic components are arranged on the first surface S1b of the second PCB 1200b and the second electronic components are arranged on the second surface S2b. The structure in (c) of FIG. 4 is a structure in which some of the electronic components that were placed on the first surface S1b in (b) of FIG. 4 are arranged on the second surface S2b. The second electronic components may be arranged at a central portion of the second surface S2b of the second PCB 1200b. Ball grids for electrical connection with the PCB which is the main substrate may be arranged on one side and another side of the second surface S2b of the second PCB 1200b. In (c) of FIG. 4, the second PCB 1200b may be configured to have a second width W2p smaller than the first width W1p. Therefore, the third structure of (c) of FIG. 4 has a width reduced by ΔWp compared to that of the second structure of (b) of FIG. 4, and thus, may be easily arranged in a free space of the PCB which is the main substrate.

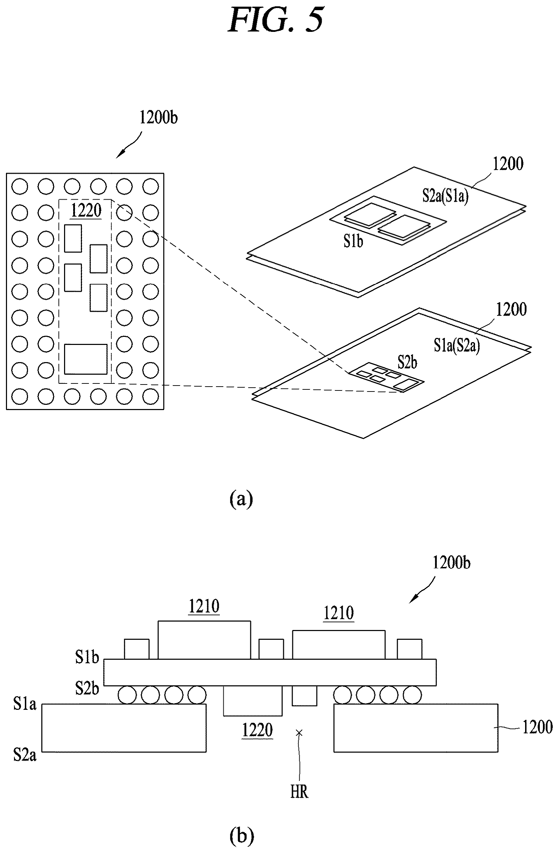

Meanwhile, in the vehicle antenna module according to this specification, the PCB which is the main substrate and the second PCB which is the NAD substrate may be configured in a stacked structure. In this regard, FIG. 5 illustrates an enlarged view and a cross-sectional view of a structure in which a PCB and the second PCB are stacked with each other. (a) of FIG. 5 is an enlarged view of a stacked structure of a PCB 1200 and the second PCB 1200b. Referring to (a) of FIG. 5, a first surface S1a or a second surface S2a of the PCB 1200 may be combined with a second surface S1b of the second PCB 1200b. The first surface S1b of the second PCB 1200b may be arranged to protrude from the second surface S2a or the first surface S1a of the PCB 1200.

(b) of FIG. 5 is a cross-sectional view of a stacked structure of the PCB 1200 and the second PCB 120b, the PCB 1200 having a hole region HR arranged to allow a second electronic component 1220 to be inserted therein. Referring to (b) of FIG. 5, the first surface S1a of the PCB 1200 and the second surface S2b of the second PCB 1200b may be combined with each other by a ball grid structure.

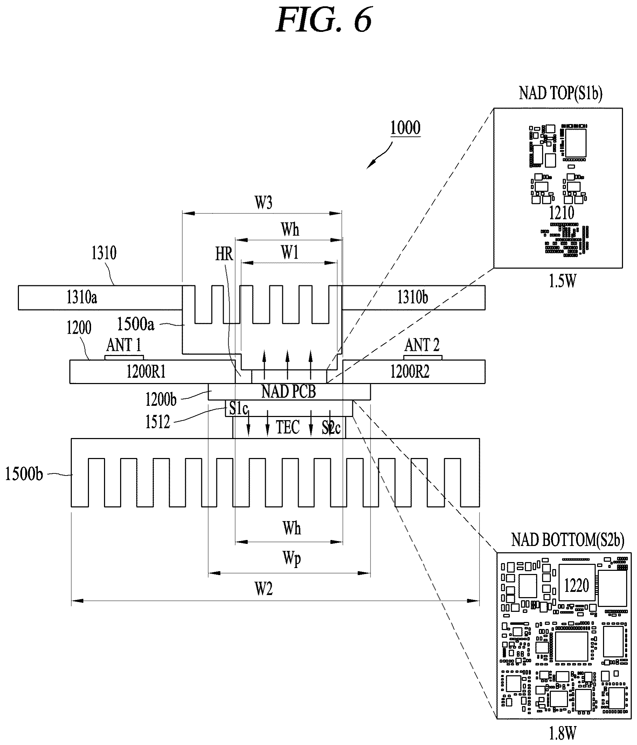

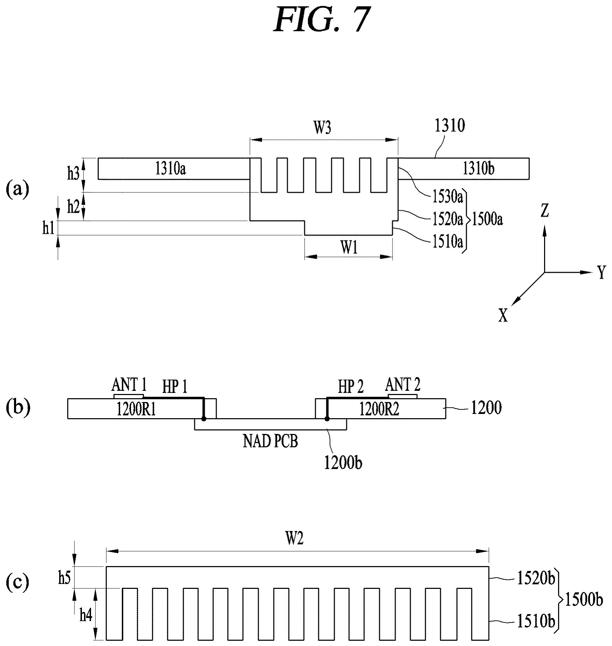

Hereinafter, a vehicle antenna module including a plurality of heat sinks according to this specification is to be described. In this regard, FIG. 6 is a cross-sectional view of the vehicle antenna module including a plurality of heat sinks according to this specification. FIG. 7 illustrates a structure in which structures of first and second heat sinks shown in FIG. 6 are combined with the PCB and the second PCB. (a) of FIG. 7 illustrates a structure in which a first heat sink 1500a having first to third metal structures 1510a, 1520a, and 1530a is combined with a first cover 1310. (b) of FIG. 7 illustrates first and second heat transfer paths HP1 and HP2 from one side and another side of the second PCB 1200b to first and second antennas ANT1 and ANT2 in a combination structure of the PCB 1200 and the second PCB 1200b, respectively. (c) of FIG. 7 illustrates a second heat sink 1500b including fourth and fifth metal structures 1510b and 1520b.

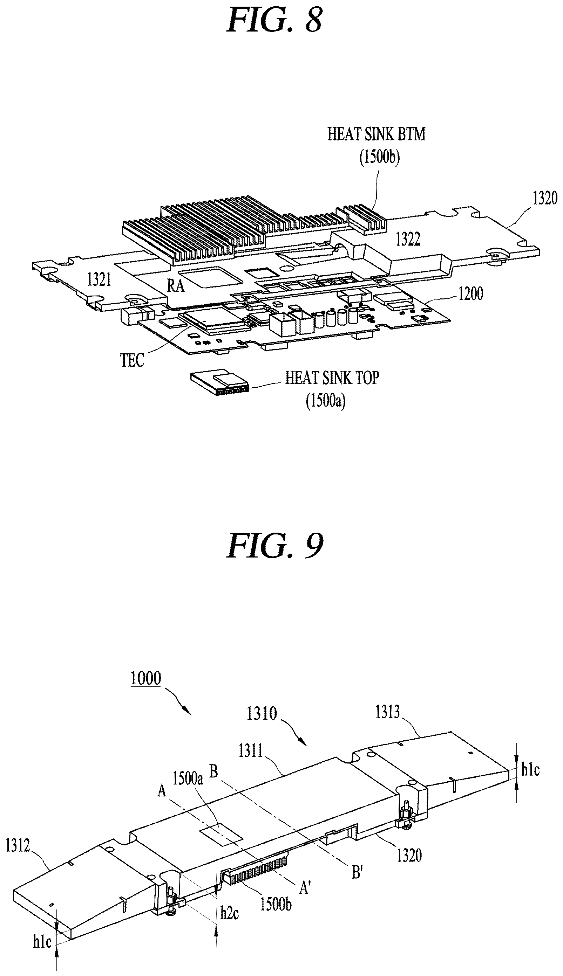

Meanwhile, FIG. 8 is an exploded perspective view of the vehicle antenna module of FIG. 6. Referring to FIGS. 6 to 8, the vehicle antenna module including a plurality of heat sinks according to this specification is described. In this regard, an antenna module having a plurality of communication modules and a heat dissipation structure may be provided in a vehicle. An optimal heat dissipation structure may be implemented by taking into account an arrangement structure of electronic components placed on both surfaces of a substrate or on different substrates. An antenna module having a plurality of communication modules and a heat dissipation structure may be provided in a vehicle. The optimal heat dissipation structure may be provided by taking into account optimal shapes and arrangement structures of a plurality of covers and heat sinks. The heat dissipation structure may be optimized for each electronic component arranged on a plurality of surfaces of the PCB. Heat dissipation performance may be improved while minimizing a whole height of the antenna module. Antenna performance may be improved while a height of the antenna module mounted in the vehicle is maintained at a certain level or greater. A heat dissipation structure in which arrangement structures of antennas capable of operating in a wide band and electronic components are taken into account may be applied to a vehicle to support various communication systems. Heat generated from the electronic components may be efficiently dissipated to outside of the antenna module through a plurality of heat sink structures. An optimized heat dissipation structure may be provided by taking into account a heat transfer path along a signal path within the antenna module.

Referring to FIGS. 6 to 8, the antenna module 1000 may include the PCB 1200, the second PCB 1200b, the first heat sink 1500a, and the second heat sink 1500b. The antenna module 1000 may further include the hole region HR arranged in the PCB 1200.

The PCB 1200 may have at least one antenna element arranged on the first surface. The first surface S1b of the second PCB 1200b may be combined with the second surface of the PCB 1200. The second PCB 1200b may have a first electronic component 1210 placed on the first surface S1b and the second electronic component 1220 placed on the second surface S2b. The second PCB 1200b may be referred to as a network access device (NAD) substrate, as electronic components for 5G wireless communication are arranged thereon.

Power consumed by the first electronic component 1210 arranged on the first surface S1b of the second PCB 1200b may have a first power value. Power consumed by the second electronic component 1220 arranged on the second surface S2b of the second PCB 1200b may have a second power value. The second power value may be set to a value greater than the first power value. For example, the first power value may be 1.5 W and the second power value may be 1.8 W. Therefore, the first and second heat sinks 1500a and 1500b need to be designed so that second heat discharged through the second surface S2b of the second PCB 1200b is discharged more effectively than first heat discharged through the first surface S1b.

The first heat sink 1500a may be arranged to be in contact with the first electronic component 1210 placed on the first surface S1b of the second PCB 1200b. The second heat sink 1500b may be arranged to be in contact with the second electronic component 1220 placed on the second surface S2b of the second PCB 1200b. The hole region HR may be arranged in a central portion of the PCB 1200b to accommodate the first electronic component 1210.

A first width W1 of a lower end of the first heat sink 1500a may be configured to be smaller than a width Wh of the hole region HR so that at least a portion of the first heat sink 1500a is inserted into the hole region HR. The at least a portion of the first heat sink 1500a inserted into the hole region HR may be in contact with the first electronic component 1210 arranged on the first surface S1b of the second PCB 1200b and accommodated in the hole region HR. Configuration may be performed to dissipate heat generated from the first electronic component 1210 arranged on the first surface S1b of the second PCB 1200b by the at least a portion of the first heat sink 1500a inserted into the hole region HR. Meanwhile, a second width W2 of the second heat sink 1500b may be configured to be greater than a width Wp of the second PCB 1200b to dissipate heat generated from the second electronic component 1220 placed on the second surface S2b of the second PCB 1200b.

The first width W1 of the lower end of the first heat sink 1500a is configured to be smaller than the hole region HR of the PCB 1200, and the second width W2 of the second heat sink 1500b is configured to be greater than the width Wp of the second PCB 1200b. Accordingly, first heat generated from the first electronic component 1210 placed on the first surface S1b of the second PCB 1200b may be dissipated intensively through the first heat sink 1500a through the hole region HR of the PCB 1200 which is the main board. Additionally, second heat through the second electronic component 1220 arranged on the second surface S2b of the second PCB 1200b may be dissipated through the second heat sink 1500b.

The antenna module 1000 may further include a first cover 1310 and a second cover 1320 coupled to the first heat sink 1500a and the second heat sink 1500b, respectively. The first cover 1310 and the second cover 1320 may be referred to as an upper cover and a lower cover, respectively. The first cover 1310 may be configured to be coupled to a side surface portion of an upper region of the first heat sink 1500a. A third width W3 of an opening region of the first cover 1310 into which the first heat sink 1500a is inserted may be configured to be greater than the first width W1 of the lower end of the first heat sink 1500a.

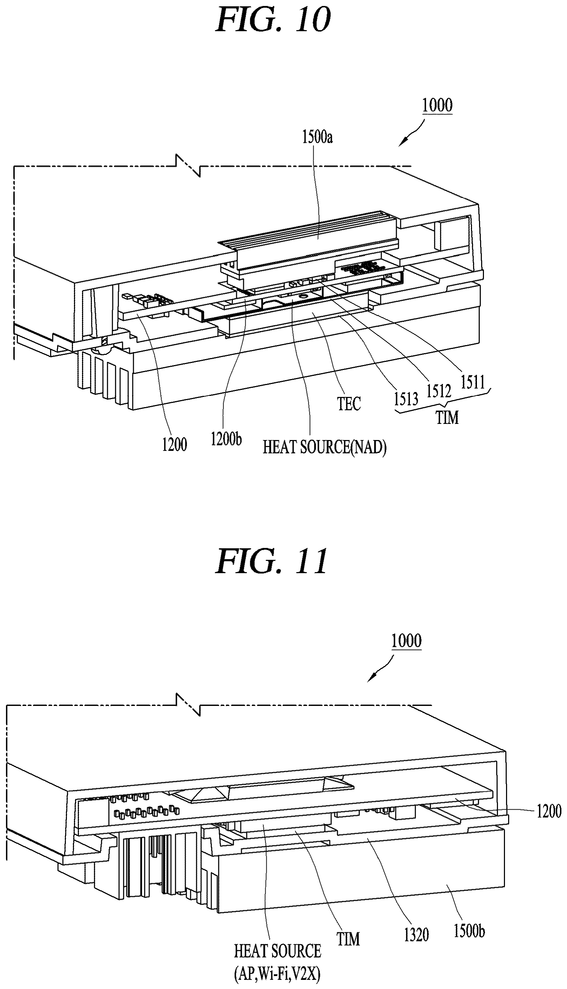

Meanwhile, a first cover which is an upper cover of the vehicle antenna module according to this specification may be configured to have a streamlined or inclined structure to correspond to a roof shape of the vehicle. In this regard, FIG. 9 is a perspective view of a vehicle antenna module including a first cover configured to have a horizontal structure and an inclined structure. FIG. 10 is a cross-sectional view of an antenna module taken along line AA' in which first and second heat sinks are included. FIG. 11 is a cross-sectional view of the antenna module take along line BB' in which the second heat sink is included.

Referring to FIG. 9, the first cover 1310 may include a horizontal region 1311, a first inclined region 1312, and a second inclined region 1313. The horizontal region 1311 of the first cover 1310 may be arranged in parallel with a horizontal plane. The first inclined region 1312 and the second inclined region 1313 may be arranged to be inclined at a predetermined angle with respect to a horizontal plane arranged in parallel with the horizontal region 1311 of the first cover 1310. The first heat sink 1500a may be arranged on the horizontal region 1311 of the first cover 1310. The second heat sink 1500b may be arranged on the horizontal region 1311 of the first cover 1310.

The first inclined region 1312 of the first cover 1310 may be arranged to be inclined to cause a height to decrease from one side end portion of the horizontal region 1311 to an end portion of the first inclined region 1312. The second inclined region 1313 of the first cover 1310 may be arranged to be inclined to cause a height to decrease from another end portion of the horizontal region 1311 to an end portion of the second inclined region 1313. The first and second inclined regions 1312 and 1313 may be configured to have a first height h1c from a lower end portion to an upper end portion at first and second points where one side end portion and another side end portion are placed. The first and second inclined regions 1312 and 1313 may be configured to have a second height h2c from a lower end portion to an upper end portion at third and fourth points at which the first and second inclined regions 1312 and 1313 are connected to the horizontal region 1311. The horizontal region 1311 may be configured to have a second height h2c from a lower end portion to an upper end portion. The second height h2c may be configured to be greater than the first height h1c.

Referring to FIGS. 9 and 10, the antenna module may have the first and second heat sinks 1500a and 1500b located along a cross-section taken along line AA'. The first heat sink 1500a may be in contact with a first electronic component on a first surface of the second PCB 1200b through a thermoelectric material TIM of a first thermoelectric layer 1511. The second heat sink 1500b may be in contact with the second electronic components on the second surface of the second PCB 1200b through thermoelectric materials TIM of second and third thermoelectric layers 1512 and 1513. Among the second electronic components on the second surface of the second PCB 1200b, a NAD may operate as a heat source.

Referring to FIGS. 9 and 11, the second heat sinks 1500a and 1500b may be arranged along a cross-section of the antenna module taken along line BB'. The second heat sink 1500b may be in contact with electronic components on a second surface of the PCB 1200 through the thermoelectric material TIM of the second and third thermoelectric layers 1512 and 1513. Among the electronic components on the second surface of the PCB 1200b, an AP module, a Wi-Fi module, a V2X module, or the like may operate as a heat source.

Referring to FIGS. 6 to 11, a cover structure and a heat sink structure of the vehicle antenna module according to this specification are described. The second cover 1320 may have a recessed area RA arranged so that the second heat sink 1500b is inserted therein. The second cover 1320 may be combined with a metal structure inside a vehicle roof through a first region 1321 on one side of the recess area RA and a second region 1322 on another side thereof. A first region 1310R1 and a second region 1310R2 of the first cover 1310 adjacent to one side and another side of the first heat sink 1500a, respectively, may be made of a dielectric material that transmits a radio wave. The second cover 1320 combined with the metal structure inside the vehicle roof may be made of a metallic material to improve heat dissipation characteristics.

The first heat sink 1500a may include a plurality of metal structures. The first heat sink 1500a may be configured to include the first metal structure 1510a, the second metal structure 1520a, and the third metal structure 1530a.

The first metal structure 1510a may be configured to have the first width W1 and a first height h1 so that at least a portion of the first metal structure 1510a is inserted into the hole region HR of the PCB 1200. The second metal structure 1520a may be connected to the first metal structure 1510a. The second metal structure 1520a may be arranged on an upper region of the first metal structure 1510a to have a second height h2 in a Z-axis direction. The third metal structure 1530a may be connected to the second metal structure 1520a. The third metal structure 1530a may be arranged on an upper region of the second metal structure 1520a to have a third height h3 in the Z-axis direction. The third metal structure 1530a may have a side surface portion combined with the first cover 1310. The third height h3 of the third metal structure 1530a may be configured to be greater than a thickness of the first cover 1310.

The third metal structure 1530a may include a plurality of metal members arranged in the Z-axis direction to be apart from each other in parallel with a horizontal axis direction. The third width h3 of the third metal structure 1530a may be configured to be greater than the second width h2 of the second metal structure 1520a. Accordingly, first heat generated from the first electronic component 1210 may be dissipated between the plurality of metal members of the third metal structure 1530a to outside of the first cover 1310. A first heat transfer path of the first heat may be increased by the third metal structure 1530a having the third height h3 configured to be greater than the second height h2 and including the plurality of metal members. Accordingly, the first heat generated from the first electronic component 1210 may be effectively dissipated to outside of the first cover 1310.

The second width h2 of the third metal structure 1520a may be configured to be greater than the first width h1 of the first metal structure 1510a. Accordingly, the first metal structure 1510a of the first heat sink 1500a may be inserted into the hole region HR of the PCB 1200 to minimize a whole height of the first heat sink 1500a.

Meanwhile, a width W3 of the second metal structure 1520a of the first heat sink 1500a may be configured to be identical to a third width W3 of the third metal structure 1530a. The first width W1 of the first metal structure 1510a may be configured to be smaller than the third width W3 of each of the second metal structure 1520a and the third metal structure 1523a.

Meanwhile, the vehicle antenna module according to this specification may have a heat dissipation structure optimized through a thermoelectric element. In this regard, the second PCB 1200b implemented as a NAD substrate consumes more power than the PCB 1200. Therefore, the second PCB 1200b may be coupled to the second heat sink 1500b via a thermoelectric element TEC. In addition, the antenna module 1000 for a vehicle may further include the thermoelectric element TEC.

The thermoelectric element TEC may be arranged between the second heat sink 1500b and the second electronic component 1220 arranged on the second surface S2b of the second PCB 1200b. The thermoelectric element TEC may be configured to absorb second heat generated from the second electronic component 1220 arranged on the second surface S2b of the second PCB 1200b. The first electronic component 1210 arranged on the first surface S1b of the second PCB 1200b may be coupled to a lower end of the first heat sink 1500a through a thermoelectric material of the first thermoelectric layer 1511.

The second electronic component arranged on the second surface S2b of the second PCB 1200b may improve heat dissipation performance through the thermoelectric element TEC and a thermoelectric material of the second thermoelectric layer 1512. A first surface S1c of the thermoelectric element TEC may be in contact with the second electronic component 1220 through the thermoelectric material of the second thermoelectric layer 1512. A second surface S2c of the thermoelectric element TEC may be in contact with the second heat sink 1500b.

The second heat sink 1500b may also include a plurality of metal structures, partially similarly to the first heat sink 1500a. The second heat sink 1500b may be arranged in the horizontal region 1311 of the first cover 1310 to overlap the first heat sink 1500a in the Z-axis direction.

The second heat sink 1500b may be configured to include the fourth metal structure 1510b and the fifth metal structure 1520b. The fourth metal structure 1510b may be arranged to be in contact with the thermoelectric element TEC and have a second width W2 and a fourth height h4. The fifth metal structure 1520b may be connected to the fourth metal structure 1510b. The fifth metal structure 1520b may be configured to have the second width W2 and a fifth height h5. The fourth metal structure 1510b may include a plurality of second metal members arranged in the Z-axis direction to be apart from each other in parallel with a horizontal axis direction. The fourth height h4 of the fourth metal structure 1510b may be configured to be greater than the fifth height h5 of the fifth metal structure 1520b.

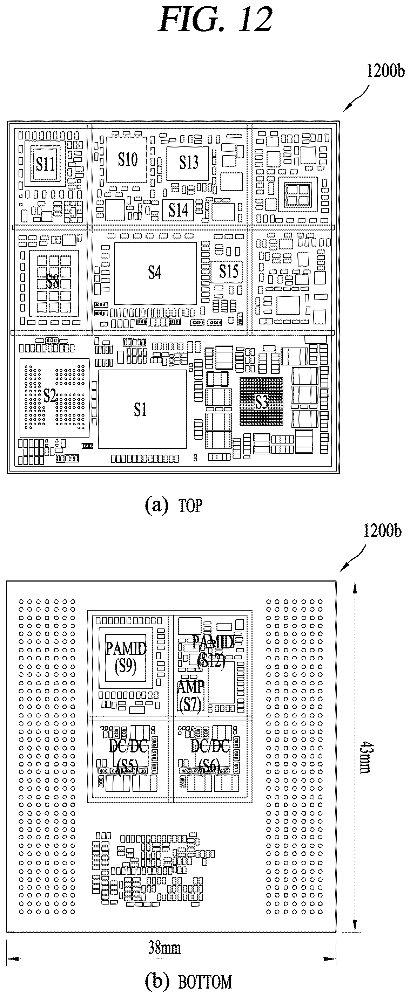

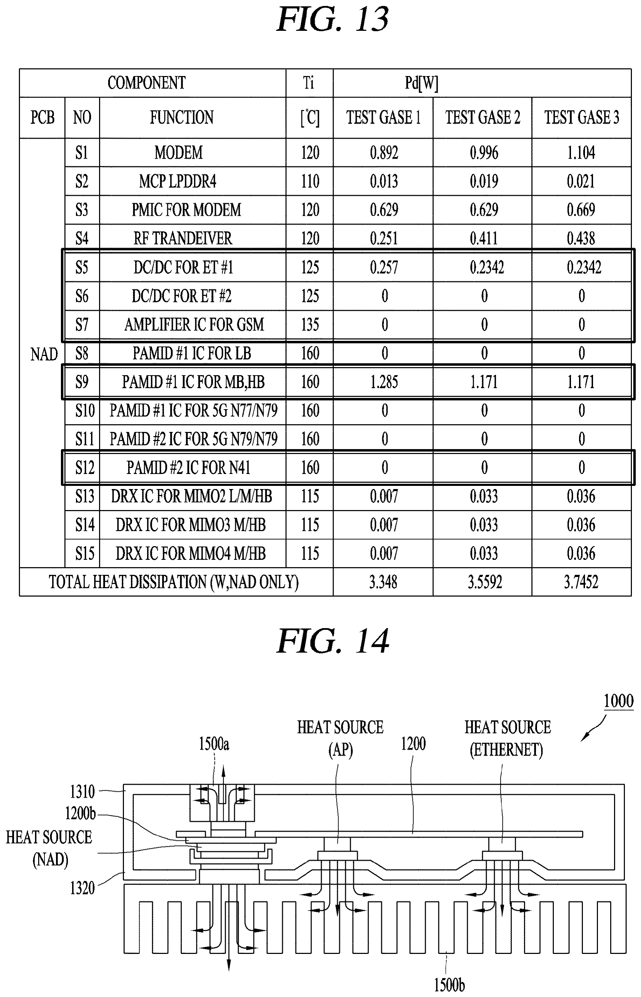

Meanwhile, electronic components arranged on the first surface S1b and the second surface S2b of the second PCB 1200b corresponding to a NAD substrate are described hereinafter. In this regard, FIG. 12 illustrates electronic components arranged on first and second surfaces of the second PCB arranged in the antenna module according to the present specification. FIG. 13 shows the electronic components arranged on the first and second surfaces of the second PCB of FIG. 12, and values of power consumption at particular temperatures.

Referring to FIGS. 6 to 13, the first electronic component 1210 arranged on the first surface S1b of the second PCB 1200b may include at least one among a modem S1, an RF transceiver S4, a power management chip S3, and first power amplifiers S8, S10, and S11. The first electronic component 1210 may further include a memory S2 and DRX ICs S13, S14, and S15. The modem S1 and the power management chip S3 arranged on a lower region of the first surface S1b of the second PCB 1200b may operate at a temperature of about 120 degrees. The RF transceiver S4 positioned at a central portion of the first surface S1b of the second PCB 1200b may also operate at a temperature of about 120 degrees. Since values of power consumed by the modem S1 and the power management chip S3 are 0.8 W and 0.6 W or greater, respectively, heat generated by the modem S1 and the power management chip S3 need to be dissipated. The first power amplifiers S8, S10, and S11 on the first surface S1b of the second PCB 1200b may operate at a temperature of about 160 degrees.

The second electronic component 1220 arranged on the second surface S2b of the second PCB 1200b may include DC/DC converters S5 and S6, and second power amplifiers S7, S9, and S12. The second PCB 1200b may be arranged in an area having a predetermined size. For example, the second PCB 1200b may be arranged in a limited area of 38 mm X 43 mm.

The first power amplifier S8 may be configured to operate in a low band (LB) which is a first frequency band of 4G/5G wireless communications. The first power amplifier S10 may be configured to operate in an n77/n79 band for 5G wireless communication. The first power amplifier S11 may be configured to operate in an n79/n79 band for 5G wireless communication. The low band (LB) which is the first frequency band may be set to 617 to 960 MHz, but is not limited thereto and may be changed depending on applications. For example, the n77 band for 5G wireless communication may be set to 3300 to 4200 MHz, but is not limited thereto and may be changed according to applications. For example, the n79 band for 5G wireless communication may be set to 4400 to 5000 MHz, but is not limited thereto and may be changed according to applications.

The second power amplifier S7 may be configured to operate in a global system for mobile communication (GSM) frequency band. The second power amplifier S9 may be configured to operate in a mid-band (MB) and a high band (HB) for 5G wireless communication. The mid-band (MB) which is the second frequency band may be set to 1520 to 4500 MHz, but is not limited thereto and may be changed depending on applications. The high band (HB) which is a third frequency band may be set to 4500 to 6000 MHz, but is not limited thereto and may be changed depending on applications. The second power amplifier S12 may be configured to operate in an n41 band for 5G wireless communication. For example, the n41 band for 5G wireless communication may be set to 2496 to 2690 MHz, but is not limited thereto and may be changed according to applications.

The DC/DC converters S5 and S6 may operate at a temperature of about 125 degrees. The second power amplifier S7 may operate at a temperature of about 135 degrees. The second power amplifiers S9 and S12 may operate at a temperature of about 160 degrees. Power consumed by the second power amplifier S9 operating in the mid-band (MB) and the high band (HB) for 5G wireless communication has a value of approximately 1.1 to 1.3 W. Thus, heat generated from the second power amplifier S9 needs to be dissipated.

Accordingly, heat generated from the first power amplifiers S8, S10, and S11 arranged on the first surface S1b of the second PCB 1200b may be dissipated through the first heat sink 1500a. Heat generated from the second power amplifiers S7, S9, and S12 arranged on the second surface S2b of the second PCB 1200b may be dissipated through the second heat sink 1500b.

Meanwhile, in the antenna module according to this specification, antenna elements arranged in different regions of a PCB in correspondence with one side and another side of a first heat sink may dissipate heat while radiating signals using different methods. In this regard, a first antenna element ANT1 may be arranged in a first region 1200R1 of the PCB 1200 in correspondence with a first region 1310a of the first cover 1310. A second antenna element ANT2 may be arranged in a second region 1200R2 of the PCB 1200 in correspondence with a second region 1310b of the first cover 1310.

In this regard, more heat may be generated when the first and second antenna elements ANT2 operate simultaneously in different frequency bands. Therefore, when the first and second antenna elements ANT2 operate simultaneously in different frequency bands, a heat dissipation mechanism may be configured as described below.

The first antenna element ANT1 may receive and/or transmit a signal in a low band in combination with the first power amplifier S8 arranged on the first surface S1b of the second PCB 1200b. The second antenna element ANT2 may simultaneously receive and/or transmit signals in the mid-band or the high band in combination with the second power amplifier S9 arranged on the second surface S2b of the second PCB 1200b. In this regard, heat generated from the first power amplifier S8 may be dissipated through the first heat sink 1500a, and simultaneously, heat generated from the second power amplifier S9 may be dissipated through the second heat sink 1500b.

An antenna module may be designed to dissipate heat transferred from the first electronic component 1210 to the first antenna element ANT1 and heat transferred from the second electronic component 1220 to the second antenna element ANT2. To do so, a second width W2 of the second heat sink 1500b may be configured to be greater than a distance G1 from an end portion of the first antenna element ANT1 to an end portion of the second antenna element ANT2. In this regard, the first heat transfer path HP1 may be defined from the second PCB 1200b to the end portion of the first antenna element ANT1 through the PCB 1200. Additionally, the second heat transfer path HP2 may be configured from the second PCB 1200b to the end portion of the second antenna element ANT2 through the PCB 1200. The distance G1 from the end portion of the antenna element ANT1 to the end portion of the second antenna element ANT2 may be defined to include the first and second heat transfer paths HP1 and HP2. Thus, the second width W2 of the second heat sink 1500b is configured to be greater than lengths of the first and second heat transfer paths HP1 and HP2. Accordingly, heat generated from the first and second power amplifiers S8 and S9 may be effectively dissipated.

Meanwhile, the PCB 1200 and the second PCB 1200b of the vehicle antenna module according to this specification may be implemented as multilayer PCBs in which a plurality of layers are stacked in a Z-axis direction. In this regard, a communication block for 5G communication, a first ground layer, an RF signal path, and a second ground layer may be arranged on a first layer, a second layer, a third layer, and a fourth layer of the second PCB 1200, respectively. A NAD module and a power management chip (PMIC) may be arranged as a communication block on the first layer. The communication block including the NAD module and the power management chip (PMIC) may be arranged inside a shield can.

The first ground layer and the second ground layer may be arranged on the second layer and the fourth layer which are regions located above and below the RF signal path of the third layer, respectively, such that the RF signal path may be configured to have a strip line structure. The first ground layer may be arranged on the second layer to isolate signals radiating from an oscillator element. A switched-mode power supply (SMPS) power line may be designed and placed on the third layer. The RF signal path of a transceiver block may be placed on the third layer.

An RF signal path, a third ground layer, a signal path for a global navigation satellite system (GNSS) antenna, and a fourth ground layer may be arranged on a fifth layer, a sixth layer, a seventh layer, and an eighth layer of the second PCB 1200. Power lines, data lines through which memory data is transmitted, and the RF signal path of a transceiver block may be arranged on the fifth layer. Power lines for signals output from an inverter and the third ground layer may be arranged on the sixth layer. Low dropout (LDO) power lines, software defined radio (SDR) differential signal lines, and signal lines connected to a GNSS antenna may be arranged on the seventh layer. A fourth ground layer may be placed on the eighth layer.

A power amplifier, a fifth ground layer, signal paths for first and second antennas, and a low-noise amplifier module may be arranged on a ninth layer, a tenth layer, an eleventh layer, and a twelfth layer of the second PCB 1200. Power lines for a power amplifier module and an inverter, and high-speed data lines such as peripheral component interconnect express (PCI-E) and/or universal serial bus (USB) may be arranged on the ninth layer. Power lines of a first variable power amplifier and the fifth ground layer which is a ground layer for a baseband signal, may be arranged on the tenth layer. Signal lines connected to the first and second antennas which are main antennas, and power lines for a second variable power amplifier may be arranged on the eleventh layer. The first variable power amplifier may be configured to operate in a low frequency band and the second variable power amplifier may be configured to operate in a high frequency band. Ball grid structures for solder connections and a low-noise amplifier module may be arranged on the twelfth layer.

Meanwhile, the vehicle antenna module including a plurality of heat sinks according to this specification may have a heat dissipation structure implemented using different mechanisms depending on each of a plurality of heat sources. In this regard, FIG. 14 is a conceptual diagram of a heat dissipation mechanism for electronic components on the PCB and the second PCB having a plurality of heat sources.

Referring to FIGS. 6 to 14, the PCB 1200 is arranged within an internal space defined by the first cover 1310 and the second cover 1320. The second PCB 1200b is arranged within a hole region of the PCB 1200. Heat released through an NAD module arranged on the second PCB 1200b in a first region may be located in an external space of the first cover 1310 and the second cover 1320 through the first and second heat sinks 1500a and 1500b. The NAD module may be arranged inside a separate shield can to prevent interference with external interference signals. The thermoelectric converter TEC may be arranged between the second heat sink 1500b and the NAD module.

The first heat sink 1500a may be arranged in the first region. For example, the first heat sink 1500a may be arranged in the first region of 7.3 cm³. The second heat sink 1500b may be arranged to cover first to third regions. For example, the second heat sink 1500b may be arranged in a region covering the first to third regions of 146 cm³.

Heat released from the AP module arranged on the PCB 1200 in the second region may be located in a lower region of the second cover 1320 through the second heat sink 1500b. The AP module may be arranged within a recessed space of the second cover 1320. The heat released from the AP module may be dissipated between the recessed space of the second cover 1320 and the second heat sink 1500b. Additionally, the heat released from the AP module may be dissipated to a lower space through the second heat sink 1500b.

Heat released from a communication module arranged on the PCB 1200 in the third region may be located in a lower region of the second cover 1320 through the second heat sink 1500b. The communication module may be arranged within the recessed space of the second cover 1320. For example, the communication module may be an Ethernet communication module, but is not limited thereto and may be changed according to applications. The heat released from the communication module may be dissipated between the recessed space of the second cover 1320 and the second heat sink 1500b. Additionally, the heat released from the communication module may be dissipated to a lower space through the second heat sink 1500b.

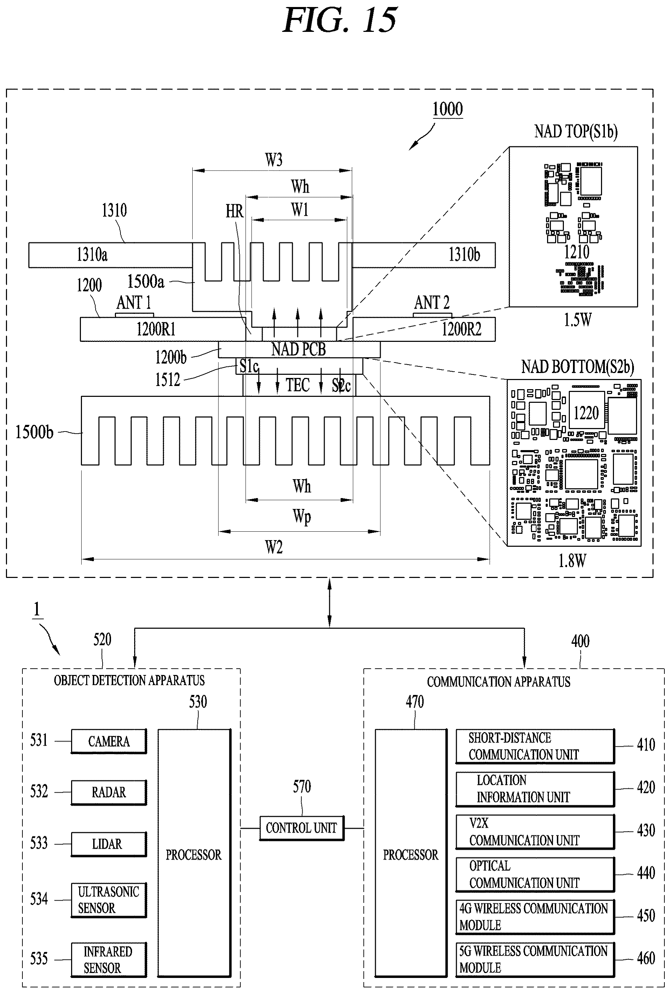

The vehicle antenna module according to one aspect of this specification has been described above. Hereinafter, a vehicle in which an antenna module according to another aspect of this specification is mounted is to be described. In this regard, FIG. 15 is a configuration diagram of a vehicle including the antenna module according to this specification. In this regard, the aforementioned descriptions of the antenna modules may be applied to a vehicle to be described below.

Referring to FIGS. 1 and 15, the antenna module 1000 may perform short-range communication, wireless communication, V2X communication, etc. independently or through a communication device 400. To do so, a processor 1400 may control to receive or transmit a signal from/to an adjacent vehicle, a RSU, and a base station through the antenna module 1000.

The processor 1400 may control to receive or transmit a signal from/to an adjacent vehicle, a road side unit (RSU), an adjacent object, and a base station through the communication device 400. Here, information related to the adjacent object may be acquired through an object detection device such as a camera 531, a radar 532, a LiDar 533, sensors 534 and 535, etc. included in a vehicle 1. Alternatively, the processor 1400 may control the communication device 400 and the antenna module 1000 to receive or transmit a signal from/to an adjacent vehicle, an RSU, an adjacent object, and a base station.

The vehicle 1 may include the antenna module 1000 and a telematics module 300. The telematics module 300 may be arranged on the second surface of the PCB 1200, but is not limited thereto and may be changed depending on applications. The telematics module 300 may be configured to include a radiofrequency integrated circuit (RFIC) which is a transceiver circuit, and the processor 1400. The antenna module 1000 may be arranged on a lower portion of a roof of the vehicle 1. The transceiver circuit 300 may be operatively coupled to the antenna module 1000. The telematics module 300 may be configured to communicate with at least one among an adjacent vehicle, a road side unit (RSU), and a base station.

The antenna module 1000 may include the PCB 1200, the second PCB 1200b, the first heat sink 1500a, and the second heat sink 1500b. The antenna module 1000 may further include the hole region HR arranged in the PCB 1200.

The PCB 1200 may have at least one antenna element arranged on a first surface. The first surface S1b of the second PCB 1200b may be combined with the second surface of the PCB 1200. The second PCB 1200b may have the first electronic component 1210 placed on the first surface S1b and the second electronic component 1220 placed on the second surface S2b. The second PCB 1200b may be referred to as a network access device (NAD) substrate, as electronic components for 5G wireless communication are arranged thereon.

Power consumed by the first electronic component 1210 arranged on the first surface S1b of the second PCB 1200b may have a first power value. Power consumed by the second electronic component 1220 arranged on the second surface S2b of the second PCB 1200b may have a second power value. The second power value may be set to a value greater than the first power value. For example, the first power value may be 1.5 W and the second power value may be 1.8 W. Therefore, the first and second heat sinks 1500a and 1500b need to be designed so that second heat discharged through the second surface S2b of the second PCB 1200b is discharged more effectively than first heat discharged through the first surface S1b.

The first heat sink 1500a may be arranged to be in contact with the first electronic component 1210 placed on the first surface S1b of the second PCB 1200b. The second heat sink 1500b may be arranged to be in contact with the second electronic component 1220 placed on the second surface S2b of the second PCB 1200b. The hole region HR may be arranged in a central portion of the PCB 1200b to accommodate the first electronic component 1210.

A first width W1 of a lower end of the first heat sink 1500a may be configured to be smaller than a width Wh of the hole region HR so that at least a portion of the first heat sink 1500a is inserted into the hole region HR. The at least a portion of the first heat sink 1500a inserted into the hole region HR may be in contact with the first electronic component 1210 arranged on the first surface S1b of the second PCB 1200b and accommodated in the hole region HR. Configuration may be performed to dissipate heat generated from the first electronic component 1210 arranged on the first surface S1b of the second PCB 1200b by the at least a portion of the first heat sink 1500a inserted into the hole region HR. Meanwhile, a second width W2 of the second heat sink 1500b may be configured to be greater than a width Wp of the second PCB 1200b to dissipate heat generated from the second electronic component 1220 placed on the second surface S2b of the second PCB 1200b.

The first width W1 of the lower end of the first heat sink 1500a is configured to be smaller than the hole region HR of the PCB 1200, and the second width W2 of the second heat sink 1500b is configured to be greater than the width Wp of the second PCB 1200b. Accordingly, first heat generated from the first electronic component 1210 placed on the first surface S1b of the second PCB 1200b may be dissipated intensively through the first heat sink 1500a through the hole region HR of the PCB 1200 which is the main board. Additionally, second heat through the second electronic component 1220 arranged on the second surface S2b of the second PCB 1200b may be dissipated through the second heat sink 1500b.

The antenna module 1000 may further include the first cover 1310 and the second cover 1320 coupled to the first heat sink 1500a and the second heat sink 1500b, respectively. The first cover 1310 and the second cover 1320 may be referred to as an upper cover and a lower cover, respectively. The first cover 1310 may be configured to be coupled to a side surface portion of an upper region of the first heat sink 1500a. A third width W3 of an opening region of the first cover 1310 into which the first heat sink 1500a is inserted may be configured to be greater than the first width W1 of the lower end of the first heat sink 1500a.

The first heat sink 1500a may include a plurality of metal structures. The first heat sink 1500a may be configured to include the first metal structure 1510a, the second metal structure 1520a, and the third metal structure 1530a.

The first metal structure 1510a may be configured to have the first width W1 and a first height h1 so that at least a portion of the first metal structure 1510a is inserted into the hole region HR of the PCB 1200. The second metal structure 1520a may be connected to the first metal structure 1510a. The second metal structure 1520a may be arranged on an upper region of the first metal structure 1510a to have a second height h2 in a Z-axis direction. The third metal structure 1530a may be connected to the second metal structure 1520a. The third metal structure 1530a may be arranged on an upper region of the second metal structure 1520a to have a third height h3 in the Z-axis direction. The third metal structure 1530a may have a side surface portion combined with the first cover 1310.

The third metal structure 1530a may include a plurality of metal members arranged in the Z-axis direction to be apart from each other in parallel with a horizontal axis direction. The third width h3 of the third metal structure 1530a may be configured to be greater than the second width h2 of the second metal structure 1520a. Accordingly, first heat generated from the first electronic component 1210 may be dissipated between the plurality of metal members of the third metal structure 1530a to outside of the first cover 1310. A first heat transfer path of the first heat may be increased by the third metal structure 1530a having the third height h3 configured to be greater than the second height h2 and including the plurality of metal members. Accordingly, the first heat generated from the first electronic component 1210 may be effectively dissipated to outside of the first cover 1310.

The second width h2 of the third metal structure 1520a may be configured to be greater than the first width h1 of the first metal structure 1510a. Accordingly, the first metal structure 1510a of the first heat sink 1500a may be inserted into the hole region HR of the PCB 1200 to minimize a whole height of the first heat sink 1500a.

Meanwhile, a width W3 of the second metal structure 1520a of the first heat sink 1500a may be configured to be identical to a third width W3 of the third metal structure 1530a. The first width W1 of the first metal structure 1510a may be configured to be smaller than the third width W3 of each of the second metal structure 1520a and the third metal structure 1523a.

Meanwhile, in a vehicle according to this specification, a heat dissipation structure may be optimized through a thermoelectric element. In this regard, the second PCB 1200b implemented as a NAD substrate consumes more power than the PCB 1200. Therefore, the second PCB 1200b may be coupled to the second heat sink 1500b via a thermoelectric element TEC. In addition, the antenna module 1000 for the vehicle may further include the thermoelectric element TEC.

The thermoelectric element TEC may be arranged between the second heat sink 1500b and the second electronic component 1220 placed on the second surface S2b of the second PCB 1200b. The thermoelectric element TEC may be configured to absorb second heat generated from the second electronic component 1220 arranged on the second surface S2b of the second PCB 1200b. The first electronic component 1210 placed on the first surface S1b of the second PCB 1200b may be coupled to a lower end of the first heat sink 1500a through a thermoelectric material of the first thermoelectric layer 1511.

The second electronic component arranged on the second surface S2b of the second PCB 1200b may improve heat dissipation performance through the thermoelectric element TEC and a thermoelectric material of the second thermoelectric layer 1512. The first surface S1c of the thermoelectric element TEC may be in contact with the second electronic component 1220 through the thermoelectric material of the second thermoelectric layer 1512. The second surface S2c of the thermoelectric element TEC may be in contact with the second heat sink 1500b.

The second heat sink 1500b may also include a plurality of metal structures, partially similarly to the first heat sink 1500a. The second heat sink 1500b may be arranged in the horizontal region 1311 of the first cover 1310 to overlap the first heat sink 1500a in the Z-axis direction.

The second heat sink 1500b may be configured to include the fourth metal structure 1510b and the fifth metal structure 1520b. The fourth metal structure 1510b may be arranged to be in contact with the thermoelectric element TEC and have a second width W2 and a fourth height h4. The fifth metal structure 1520b may be connected to the fourth metal structure 1510b. The fifth metal structure 1520b may be configured to have the second width W2 and a fifth height h5. The fourth metal structure 1510b may include a plurality of second metal members arranged in the Z-axis direction to be apart from each other in parallel with a horizontal axis direction. The fourth height h4 of the fourth metal structure 1510b may be configured to be greater than the fifth height h5 of the fifth metal structure 1520b.

The antenna module mounted on a vehicle and the vehicle including the same have been described above. Hereinafter, technical effects of such an antenna module mounted on a vehicle and the vehicle including the same are described.

According to this specification, an antenna module having a plurality of communication modules and a heat dissipation structure may be provided in a vehicle.

According to this specification, an optimal heat dissipation structure may be provided through optimal shapes and arrangement structures of a plurality of covers and heat sinks.

According to this specification, shapes of metal structures of first and second heat sinks may be optimized for a plurality of regions, respectively, to optimize a heat dissipation structure for each of electronic components arranged on a plurality of surfaces of a PCB.

According to this specification, a first heat sink may be arranged to be coupled to an upper cover to improve heat dissipation performance while minimizing a whole height of the antenna module.

According to this specification, heat generated from an electronic component may be dissipated to an upper region and a lower region through a first heat sink coupled to an upper cover and a second heat sink arranged in a lower region of a lower cover.

According to this specification, an optimized heat dissipation structure may be proposed by taking into account a heat transfer path along a signal path from a power amplifier to antenna elements capable of operating in a wide band.

Further scope of applicability of the disclosure will become apparent from the foregoing detailed description. It should be understood, however, that the detailed description and specific examples, such as the preferred embodiment of the present disclosure, are given by way of illustration only, since various changes and modifications within the spirit and scope of the present disclosure will be apparent to those skilled in the art.

In relation to the foregoing description, the antenna module mounted on the vehicle and the operation of controlling the same may be implemented by software, firmware, or a combination thereof. Meanwhile, the design of the antenna module mounted in the vehicle and a configuration of controlling the antenna module may be implemented as computer-readable codes in a program-recorded medium. The computer-readable medium may include all types of recording devices each storing data readable by a computer system. Examples of such computer-readable media may include hard disk drive (HDD), solid status disk (SSD), silicon disk drive (SDD), ROM, RAM, CD-ROM, magnetic tape, floppy disk, optical data storage element and the like. Also, the computer-readable medium may also be implemented as a format of carrier wave (e.g., transmission via an Internet). The computer may also include a controller of a terminal or vehicle, namely, a processor. Therefore, the detailed description should not be limitedly construed in all of the aspects, and should be understood to be illustrative. The scope of the disclosure should be determined by reasonable interpretation of the appended claims and all changes that come within the equivalent scope of the disclosure are included in the scope of the disclosure.

## Claims

1. An antenna module mounted on a vehicle, the antenna module comprising:
a printed circuit board (PCB) having at least one antenna element arranged on a first surface;
a second PCB having a first surface combined with a second surface of the PCB, a first electronic component arranged on the first surface, and a second electronic component arranged on a second surface;
a first heat sink arranged to be in contact with the first electronic component arranged on the first surface of the second PCB;
a second heat sink arranged to be in contact with the second electronic component arranged on the second surface of the second PCB; and
a hole region arranged in a central portion of the PCB to accommodate the first electronic component.

2. The antenna module of claim 1, wherein a first width of a lower end of the first heat sink is configured to be smaller than a width of the hole region so that at least a portion of the first heat sink is inserted into the hole region,
the inserted at least a portion of the first heat sink is configured to be in contact with the first electronic component accommodated in the hole region to dissipate heat generated from the first electronic component, and
a second width of the second heat sink is configured to be greater than a width of the second PCB to dissipate heat generated from the second electronic component.

3. The antenna module of claim 2, further comprising a first cover configured to be combined with a side surface portion of an upper region of the first heat sink,
wherein a third width of an opening region of the first cover into which the first heat sink is inserted is configured to be greater than the first width of the lower end of the first heat sink.

4. The antenna module of claim 3, wherein the first cover comprises a horizontal region arranged in parallel with a horizontal plane, and a first inclined region and a second inclined region each arranged to be inclined at a predetermined angle with respect to the horizontal plane, and the first heat sink is arranged in the horizontal region of the first cover.

5. The antenna module of claim 4, wherein the first heat sink comprises:
a first metal structure configured to have a first width and a first height such that at least a portion of the first metal structure is inserted into the hole region of the PCB;
a second metal structure connected to the first metal structure and arranged on an upper region of the first metal structure to have a second height in a Z-axis direction; and
a third metal structure connected to the second metal structure, arranged on an upper region of the second metal structure to have a third height in the Z-axis direction, and having the side surface portion combined with the first cover, and
wherein the third height of the third metal structure is configured to be greater than the second height of the second metal structure, and
the second height of the second metal structure is configured to be greater than the first height of the first metal structure.

6. The antenna module of claim 5, wherein the third metal structure comprises a plurality of metal members spaced apart from each other in parallel with a horizontal axis direction and arranged in the Z-axis direction,
a width of the second metal structure is configured to be identical to a third width of the third metal structure, and
the first width of the first metal structure is configured to be smaller than the third width of each of the second metal structure and the third metal structure.

7. The antenna module of claim 6, further comprising a thermoelectric element located between the second heat sink and the second electronic component arranged on the second surface of the second PCB to absorb heat generated from the second electronic component,
wherein the first electronic component arranged on the first surface of the second PCB is coupled to a lower end of the first heat sink through a thermoelectric material, and
a first surface of the thermoelectric element is in contact with the second electronic component through the thermoelectric material, and a second surface of the thermoelectric element is in contact with the second heat sink.

8. The antenna module of claim 7, wherein the second heat sink is arranged in the horizontal region of the first cover to overlap the first heat sink in the Z-axis direction,
wherein the second heat sink comprises:
a fourth metal structure in contact with the thermoelectric element and configured to have the second width and a fourth height; and
a fifth metal structure connected to the fourth metal structure and configured to have the second width and a fifth height, and
wherein the fourth metal structure comprises a plurality of second metal members spaced from each other in parallel with the horizontal axis direction and arranged in the Z-axis direction, and
the fourth height of the fourth metal structure is configured to be greater than the fifth height of the fifth metal structure.

9. The antenna module of claim 7, wherein the first electronic component comprises at least one among a modem, a radio frequency (RF) transceiver, a power management chip, and a first power amplifier,
the second electronic component comprises a direct current (DC)/DC converter and a second power amplifier,
the first power amplifier operates in a low band (LB), and the second power amplifier operates in a mid band (MB) and a high band (HB), and
heat generated from the first power amplifier is dissipated through the first heat sink, and heat generated from the second power amplifier is dissipated through the second heat sink.

10. The antenna module of claim 3, wherein a second cover having a recessed area arranged to have the second heat sink inserted therein is comprised, the second cover being configured to be combined with a metal structure inside a vehicle roof through a first region on one side of the recessed area and a second region on another side of the recessed area,
first and second regions of the first cover adjacent to one side and another side of the first heat sink, respectively, are made of a dielectric material that transmits a radio wave, and
the second cover is made of a metallic material.

11. The antenna module of claim 10, wherein a first antenna element is arranged in a first region of the PCB in correspondence with the first region of the first cover, and
a second antenna element is arranged in a second region of the PCB in correspondence with the second region of the first cover.

12. The antenna module of claim 11, wherein the first antenna element is coupled to the first power amplifier to receive a signal in a low band, and the second antenna element is coupled to the second power amplifier to simultaneously receive a signal in a mid band or a high band, and
heat generated from the first power amplifier is dissipated through the first heat sink, and simultaneously, heat generated from the second power amplifier is dissipated through the second heat sink.

13. The antenna module of claim 12, wherein the second width of the second heat sink is configured to be greater than a distance from an end portion of the first antenna element to an end portion of the second antenna element to dissipate heat transferred from the first electronic component to the first antenna element and heat transferred from the second electronic component to the second antenna element.

14. The antenna module of claim 1, wherein the PCB and the second PCB are implemented as multilayer PCBs in which a plurality of layers are stacked in a Z-axis direction,
a communication block for fifth-generation (5G) communication, a first ground layer, a radio frequency (RF) signal path, and a second ground layer are arranged on a first layer, a second layer, a third layer, and a fourth layer of the second PCB, respectively,
an RF signal path, a third ground layer, a signal path for a global navigation satellite system (GNSS) antenna, and a fourth ground layer are arranged on a fifth layer, a sixth layer, a seventh layer, and an eighth layer of the second PCB, respectively, and
a power amplifier, a fifth ground layer, signal paths for first and second antennas and a low-noise amplifier module are arranged on a ninth layer, a tenth layer, an eleventh layer, and a twelfth layer of the second PCB, respectively.

15. A vehicle having an antenna module mounted thereon, the vehicle comprising:
an antenna module arranged on a lower portion of a roof of the vehicle; and
a telematics module operatively coupled to the antenna module and configured to communicate with at least one among an adjacent vehicle, a road side unit (RSU), and a base station,
wherein the antenna modules comprises:
a printed circuit board (PCB) having at least one antenna element arranged on a first surface;
a second PCB having a first surface combined with a second surface of the PCB, a first electronic component arranged on the first surface, and a second electronic component arranged on a second surface;
a first heat sink arranged to be in contact with the first electronic component arranged on the first surface of the second PCB; and
a second heat sink arranged to be in contact with the second electronic component arranged on the second surface placed on the second PCB; and
a hole region arranged in a central portion of the PCB to accommodate the first electronic component.

16. The vehicle of claim 15, wherein a first width of a lower end of the first heat sink is configured to be smaller than a width of the hole region so that at least a portion of the first heat sink is inserted into the hole region,
the inserted at least a portion of the first heat sink is configured to be in contact with the first electronic component accommodated in the hole region to dissipate heat generated from the first electronic component, and
a second width of the second heat sink is configured to be greater than a width of the second PCB to dissipate heat generated from the second electronic component.

17. The vehicle of claim 16, comprising:
a first cover configured to be combined with a side surface portion of an upper region of the first heat sink; and
a second cover having a recessed area arranged to have the second heat sink inserted therein, and configured to be combined with a metal structure inside a vehicle roof through a first region on one side of the recessed area and a second region on another side of the recessed area,
wherein first and second regions of the first cover adjacent to one side and another side of the first heat sink, respectively, are made of a dielectric material that transmits a radio wave, and
the second cover is made of a metallic material.

18. The vehicle of claim 17, wherein the first heat sink further comprises:
a first metal structure configured to have a first width and a first height such that at least a portion of the first metal structure is inserted into the hole region of the PCB;
a second metal structure connected to the first metal structure and arranged on an upper region of the first metal structure to have a second height in a Z-axis direction; and
a third metal structure connected to the second metal structure, arranged on an upper region of the second metal structure to have a third height in the Z-axis direction, and having the side surface portion combined with the first cover, and
wherein the third metal structure comprises a plurality of metal members spaced apart from each other in parallel with a horizontal axis direction and arranged in the Z-axis direction,
the third height of the third metal structure is configured to be greater than the second height of the second metal structure,
the second height of the second metal structure is configured to be greater than the first height of the first metal structure,
a width of the second metal structure is configured to be identical to a third width of the third metal structure, and
the first width of the first metal structure is configured to be smaller than the third width of the third metal structure.

19. The vehicle of claim 18, further comprising a thermoelectric element located between the second heat sink and the second electronic component arranged on the second surface of the second PCB to absorb heat generated from the second electronic component,
wherein the first electronic component arranged on the first surface of the second PCB is coupled to a lower end of the first heat sink through a thermoelectric material, and
a first surface of the thermoelectric element is in contact with the second electronic component through the thermoelectric material, and a second surface of the thermoelectric element is in contact with the second heat sink.

20. The vehicle of claim 19, wherein the second heat sink is arranged in the horizontal region of the first cover to overlap the first heat sink in the Z-axis direction,
wherein the second heat sink comprises:
a fourth metal structure in contact with the thermoelectric element and configured to have the second width and a fourth height; and
a fifth metal structure connected to the fourth metal structure and configured to have the second width and a fifth height, and
wherein the fourth metal structure comprises a plurality of second metal members spaced from each other in parallel with the horizontal axis direction and arranged in the Z-axis direction, and
the fourth height of the fourth metal structure is configured to be greater than the fifth height of the fifth metal structure.
